(19) Europäisches Patentamt
European Patent Office
Office européen des brevets

(11) **EP 3 270 113 B1**

(12) **EUROPÄISCHE PATENTSCHRIFT**

(45) Veröffentlichungstag und Bekanntmachung des Hinweises auf die Patenterteilung:
**01.09.2021   Patentblatt 2021/35**

(51) Int Cl.:
*G01D 5/14* (2006.01)          *G06F 7/544* (2006.01)

(21) Anmeldenummer: **17181471.8**

(22) Anmeldetag: **14.07.2017**

(54) **VERFAHREN ZUR BERECHNUNG DER PHASENVERSCHIEBUNG ODER AMPLITUDE EINES DREI-PHASEN-SYSTEMS**

METHOD FOR CALCULATING THE PHASE SHIFT OR AMPLITUDE OF A THREE-PHASE SYSTEM

PROCÉDÉ DE CALCUL DE DÉCALAGE DE PHASE OU D'AMPLITUDE D'UN SYSTÈME TRIPHASÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.07.2016   DE 102016113126**

(43) Veröffentlichungstag der Anmeldung:
**17.01.2018   Patentblatt 2018/03**

(73) Patentinhaber: **TDK-Micronas GmbH**
**79108 Freiburg im Breisgau (DE)**

(72) Erfinder: **HUPPERTZ, Julia**
**79108 Freiburg (DE)**

(74) Vertreter: **Schmidt, Alexander**
**Sonnenberg Harrison Partnerschaft mbB**
**Postfach 33 08 65**
**80068 München (DE)**

(56) Entgegenhaltungen:
**EP-A1- 1 471 332          DE-A1-102010 003 292**
**DE-A1-102013 020 730     DE-A1-102014 109 693**
**US-A1- 2015 077 093**

**Beschreibung**

Die Erfindung betrifft ein Verfahren zur Berechnung der Phasenverschiebung oder der Amplitude eines elektromagnetischen Drei-Phasen-Systems sowie eine Vorrichtung zur Durchführung des Verfahrens und Berechnung des Winkels.

Bisher wird der Drehwinkel eines magnetischen Vektors in einem Drei-Phasen-System, z.B. einem Drehstrommotor, mit Hilfe einer sogenannten Clarke-Transformation (auch bezeichnet als Alpha-Beta Transformation) verarbeitet, welche die Daten von dem Drei-Phasen-System in ein rechtwinkliges Koordinatensystem überführt und den Drehwinkel danach mit Hilfe eines Algorithmus berechnet. Typischerweise wird der sogenannte Cordic-Algorithmus für diese Berechnung eingesetzt.

Das bisherige Verfahren hat den Nachteil, dass es einen zusätzlichen Rechenschritt am Anfang des Verfahrens benötigt, um zu entscheiden, in welchem der Quadranten der magnetische Feldvektor liegt.

Andere Verfahren zur kontaktlosen Erfassung und Berechnung des Drehwinkels sind bekannt. Zum Beispiel ist aus dem US Patent Nr. 8,736,258 (Trontelj) ein Verfahren bekannt, welches eine Vielzahl von magnetischen Sensorelementen in einem integrierten Schaltkreis verwendet. Der integrierte Schaltkreis ist unterhalb eines Dauermagneten angeordnet. Die Signale der magnetischen Sensorelemente werden zusammengefasst, um der Drehwinkel zu erfassen.

Aus der deutschen Offenlegungsschrift DE 103 20 057 A1 (Schödlbauer) ist ein Winkelaufnehmer mit Hall-Effekt-Elementen bekannt. Der Winkelaufnehmer besitzt auf einem Halbleitersubstrat acht horizontale Hallsensor-Strukturen, die in einem Winkelabstand von 45° auf einer Kreislinie um ein Symmetriezentrum herum angeordnet sind. Diese acht Sensoren bilden in der Summe vier Empfindlichkeitsachsen, von denen jeweils zwei zusammen als ein eigenständiger Winkelsensor genutzt werden können. Der Winkelaufnehmer kann den Winkel eines drehbar gelagerten Dauermagneten, welcher über den Symmetriesensor angeordnet ist, bestimmen.

Bei diesem vorbekannten Verfahren sind die Berechnungsschritte relativ kompliziert.

Weitere Verfahren zur kontaktlosen Erfassung und Berechnung des Drehwinkels sind bekannt, beispielsweise aus den deutschen Patentanmeldungen DE 10 2014 109693 A1, DE 10 2013 020730 A1 und DE 10 2010 003292 A1, aus der U.S. Patentanmeldung US 2015/077093 A1 und der europäischen Patentanmeldung EP 1 471 332 A1.

Vorgeschlagen ist ein vereinfachtes Verfahren zur Berechnung der Amplituden bzw. der Phasenverschiebung eines elektromagnetischen Drei-Phasen-Systems, welche die Erfassung von Vektorwerten entsprechend einer elektromagnetischen Größe durch drei weitgehend gleichwinklig auf einer Kreislinie angeordneten Sensoren umfasst. Diese drei weitgehend gleichwinklig auf einer Kreislinie angeordneten Sensoren liefern drei Signale als Vektorwerte, welche im Wesentlichen um 0°, 120° und 240° verschoben sind. Die Vektorwerte werden auf einen Winkel von 0° zurückgesetzt. Aus einer iterativen Berechnung kann die Phasenverschiebung bzw. die Amplitude des Drei-Phasen-Systems durch ein Cordic-Verfahren mit Hilfe der geänderten Vektorwerte berechnet werden. In einem Aspekt der Erfindung werden sechs Sensoren verwendet, um die Signale zu erfassen. Diese sechs Sensoren sind in einem Winkelabstand von 60° auf eine Kreislinie um ein Symmetriezentrum angeordnet. Die Messwerte aus den jeweiligen gegenüberliegenden Sensoren werden zusammen gebildet, um die Signale zu liefern.

Das Verfahren findet Anwendung zum Beispiel in einem System zur Berechnung eines Werts eines Drehwinkels, wobei ein Prozessor verwendet wird, um das Verfahren durchzuführen. Das Verfahren und das System können zum Beispiel in einem bürstenlosen Elektromotor eingesetzt werden.

Die Erfindung wird nun anhand der folgenden Figuren näher erläutert, es zeigen:

Fig. 1 eine Übersicht eines drehbaren Dauermagneten und des Sensors in einem integriertem Schaltkries;

Fig. 2 die Werte eines Drei-Phasen Systems;

Fig. 3 die magnetischen Vektorwerte; und

Fig. 4 den Ablauf des Verfahrens.

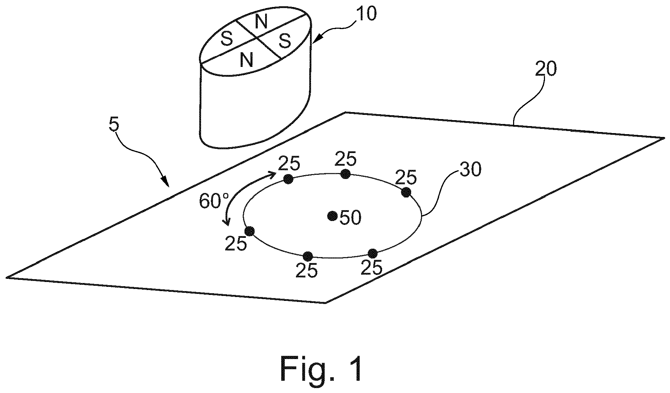

Fig. 1 zeigt eine Übersicht eines Winkelerfassungssystems 5 der vorliegenden Beschreibung, welches den Drehwinkel $\varphi$ eines drehbaren Dauermagneten 10 berechnet. Der drehbare Dauermagnet 10 ist in der dargestellten Ausführungsform ein vierpoliger Magnet und ist über eine Sensorplatte 20 angeordnet. Die Sensorplatte 20 hat sechs Sensoren zur Erfassung des magnetischen Felds von dem Dauermagneten 10, welche in einem Winkelabstand von ungefähr 60° auf einer Kreislinie 30 um ein Symmetriezentrum 50 herum angeordnet sind. Die Sensoren 25 sind beispielsweise horizontale Hall-Effekt-Sensoren, welche Signale liefern, die dem Wert des erfassten magnetischen Felds entspricht.

Die Signale aus den jeweils gegenüberliegenden Sensoren 25, d.h. jeweils um 180° versetzt, können zusammengefasst werden, um ein einzelnes Signal Su, Sv, Sw für jedes Paar zu liefern. Diese Zusammenfassung ist in Fig.

2 dargestellt und zeigt die normalisierten Signale Su, Sv, Sw für die drei Feldvektoren U, V und W, welche aus den Paaren der Sensoren 25 zusammengefasst sind.

Das Winkelerfassungssystem 5 umfasst auch einen Prozessor 40, der die Signale von den Sensoren 25 annimmt und diese nach dem folgenden Verfahren verarbeitet.

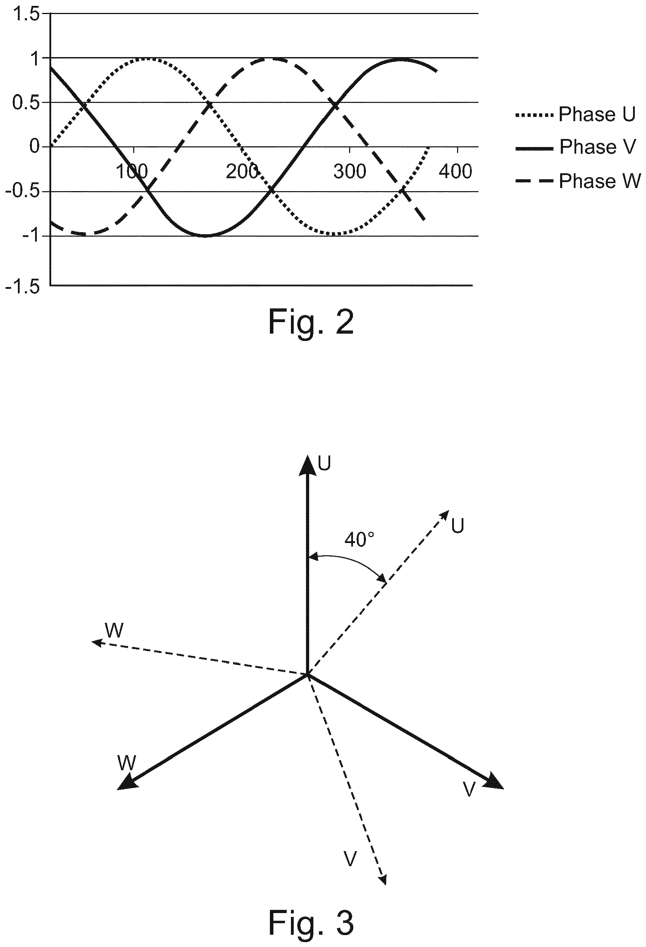

Fig. 3 zeigt die jeweiligen drei magnetischen Feldvektoren U, V und W. Hinter der vorliegenden Erfindung steht die Idee einer dieser Vektoren, zum Beispiel den U-Vektor auf einen Winkel von 0° zurückzudrehen, um somit den Winkel berechnen zu können. Der Drehwinkel $\varphi$ kann anschließend mit Hilfe des bekannten CORDIC-Verfahrens berechnet werden. Bei der vorliegenden Erfindung geht es also um die Erweiterung des CORDIC-Verfahrens auf ein Dreiphasensystem.

Das Verfahren zur Berechnung des Drehwinkels $\varphi$ wird schrittweise mit Hilfe der folgenden Vorschriften berechnet. Aus den drei gemessenen Sensorsignalen Su, Sv, Sw und einem Drehwinkel $\varphi$ werden neue Signale Su', Sv', Sw' und ein neuer Drehwinkel $\varphi'$ berechnet:

$$Su' = Su - A*(Sv - Sw), \qquad (1)$$

$$Sv' = Sv - A*(Sw - Su), \qquad (2)$$

$$Sw' = Sw - A*(Su - Sv), \qquad (3)$$

$$\varphi' = \varphi + R * \arctan(\sqrt{3} * 2^n) \qquad (4)$$

Der Parameter A ist als $A = R * 2^n$ gewählt, wobei n eine ganze Zahl ist. Durch die Auswahl einer Zweierpotenz reduziert sich die Multiplikation zu einer Schiebeoperation. Der Parameter R ist entweder +1 oder -1 und entspricht der Drehrichtung, also dem Vorzeichen von Sw-Sv.

Das Verfahren startet mit den gemessenen Werten Su, Sv, Sw, mit $\varphi$=0 und n=1 und wird mehrmals iteriert. Damit kommt die Iteration nur mit Additionsoperationen und ohne Multiplikation aus. Zur Berechnung des Drehwinkels $\varphi$ kann, z. B. für eine Winkelauflösung von 1 Grad eine Koeffizententabelle mit den Werten von $\arctan(\sqrt{3} * 2^n)$ für n = 1, 0, ...,-12 verwendet werden.

| Rotation $2^n$ | Rotation * $\sqrt{3}$ | arctan [° ] | max Drehbereich |
|---|---|---|---|
| 2 | 3,46410 | 73,89789 | 222,77401 |
| 1 | 1,73205 | 60,00000 | 148,87612 |
| 0,5 | 0,86603 | 40,89339 | 88,87612 |
| 0,25 | 0,43301 | 23,41322 | 47,98273 |
| 0,125 | 0,21651 | 12,21635 | 24,56951 |
| 0,0625 | 0,10825 | 6,17839 | 12,35316 |
| 0,03125 | 0,05413 | 3,09820 | 6,17477 |
| 0,015625 | 0,02706 | 1,55023 | 3,07656 |
| 0,007813 | 0,01353 | 0,77526 | 1,52633 |
| 0,003906 | 0,00677 | 0,38765 | 0,75107 |
| 0,001953 | 0,00338 | 0,19383 | 0,36342 |
| 0,000977 | 0,00169 | 0,09691 | 0,16960 |
| 0,000488 | 0,00085 | 0,04846 | 0,07268 |
| 0,000244 | 0,00042 | 0,02423 | 0,02423 |

Die Spalte "max Drehbereich" dient nur zur Überprüfung des Verfahrens. Aus der obersten Zeile ist zu erkennen, dass der Drehbereich einen maximalen Wert von 222° erfassen kann.

In einer weiteren Ausführungsform werden die Signale Su', Sv', Sw' bei jedem Iterationsschritt mit dem Wert cos(p) skaliert, wobei $p$ = arctan $(\sqrt{3} * 2^n)$ ist. Also z.B. (aus 1)

$$Su` = \cos(p)*(Su - A*(Sv - Sw)) \qquad (5)$$

Dadurch bleibt die Amplituden-Skalierung der Komponenten erhalten und der Wert von Su' am Ende der Iteration entspricht der Amplitude des ursprünglichen Messsignals. Die Gleichung (5) benötigt je Iterationsschritt drei Multiplikationen, d.h. bei 10 Iterationsschritte werden insgesamt 30 Multiplikationen verwenden. Um diesen Rechenaufwand zu minimieren kann die Gleichung ohne die Skalierung cos(p) zunächst durchgeführt werden. Die Skalierung wird am Ende von allen Iterationsschritten anschließend einmal ausgeführt, da das Produkt aller cos(p) für eine feste Anzahl von Iterationsschritten konstant ist. Daher werden nur drei Multiplikationen in diesem Aspekt durchgeführt. Der Wert der Skalierung kann auch in der Koeffizententabelle abgespeichert werden.

Die Vektorwerte können auch während der Durchführung der Iterationsschritte skaliert werden, damit die Vektorwerte nicht zu groß werden, z.B. zur Vermeidung von Überläufen in dem Rechenwerk. Diese Skalierung kann mit Hilfe einer Schieberationen erfolgen und muss bei der abschließenden Skalierung berücksichtigt werden.

Das Verfahren dieser Beschreibung ergibt sich aus den Eigenschaften eines Drei-phasen-Systems. Es ist bekannt, dass die Summe der drei Feldvektoren U, V und W in einem Drei-Phasen-System Null sein muss. Daraus ergibt sich folgende Formel:

$$\vec{p_u} + \vec{p_v} + \vec{p_w} = \vec{0} \qquad (6)$$

Die Summe der jeweiligen Komponente, z.B. auf der x-Achse, ist daher:

$$p_{u,x} + p_{v,x} + p_{w,x} = 0 \qquad (7)$$

Jeder der Feldvektoren hat die gleiche Länge $V$:

$$|\vec{p_u}| = |\vec{p_v}| = |\vec{p_w}| = V \qquad (8)$$

Daraus ergibt sich:

$$|\vec{p_u}| + |\vec{p_v}| + |\vec{p_w}| = 3V \qquad (9)$$

Die Komponente auf der jeweiligen x-Achse und y-Achse sind:

$$p_{u,x}^2 + p_{v,x}^2 + p_{w,x}^2 = {}^3/_2 V^2 \qquad (10)$$

$$p_{u,y}^2 + p_{v,y}^2 + p_{w,y}^2 = {}^3/_2 V^2 \qquad (11)$$

$$|\vec{p_u}| = p_{u,x}^2 + p_{u,y}^2 = V^2 \qquad (12)$$

Somit können die Komponente in der y-Richtung bestimmt werden. Aus (12) leitet man die Länge des Vektors ab:

$$p_{u,y}^2 = V^2 - p_{v,x}^2 \qquad (13)$$

Daraus ergibt sich die folgenden Formeln:

$$p_{u,x}^2 = \frac{p_{u,x}^2 + p_{v,x}^2 + p_{w,x}^2}{1.5} - \frac{1.5}{1.5} p_{u,x}^2 \qquad (14)$$

$$p_{u,x}^2 = \frac{-0.5 p_{u,x}^2 + p_{v,x}^2 + p_{w,x}^2}{1.5} \qquad (15)$$

Aus (5):

$$p_{u,x}^2 = \frac{-0.5(-p_{v,x} - p_{w,x})^2 + p_{v,x}^2 + p_{w,x}^2}{1.5} \qquad (16)$$

(11) wird um 2 multipliziert:

$$p_{u,x}^2 = \frac{-p_{v,x}^2 - 2p_{v,x}\cdot p_{w,x} - p_{w,x}^2 + p_{v,x}^2 + p_{w,x}^2}{3} \qquad (17)$$

Mit der binomischen Formel

$$p_{u,y}^2 = \frac{(p_{v,x} - p_{w,x})^2}{3} \qquad (18)$$

Daraus ergibt sich wie bei (1):

$$p_{u,y} = \pm \frac{1}{\sqrt{3}} (p_{v,x} - p_{w,x}) \qquad (19)$$

Aus dem Cordic-Verfahren wird eine Rotationsmatrix verwendet. Die neuen Werte $\begin{pmatrix} x \\ y \end{pmatrix}$ nach jeder Iteration sind aus den alten Werten $\begin{pmatrix} x_{old} \\ y_{old} \end{pmatrix}$ wie folgt abgeleitet:

$$\begin{pmatrix} x \\ y \end{pmatrix} = \begin{pmatrix} \cos\varphi & -\sin\varphi \\ \sin\varphi & \cos\varphi \end{pmatrix} \begin{pmatrix} x_{old} \\ y_{old} \end{pmatrix} \qquad (20)$$

Daher:

$$\begin{pmatrix} x \\ y \end{pmatrix} = \frac{1}{\cos\varphi} \begin{pmatrix} 1 & -\tan\varphi \\ \tan\varphi & 1 \end{pmatrix} \begin{pmatrix} x_{old} \\ y_{old} \end{pmatrix} \qquad (21)$$

Betrachten wir nur die Berechnung der X-Komponente für den U-Vektor:

$$x = \frac{1}{\cos\varphi} (1 - \tan\varphi) \begin{pmatrix} p_{u,x,old} \\ p_{u,y,old} \end{pmatrix} \qquad (22)$$

Aus (19):

$$p_{u,x} = \frac{1}{\cos \varphi} \left[ p_{u,x,old} - \tan\varphi \frac{1}{\sqrt{3}} \left( p_{v,x,old} - p_{w,x,old} \right) \right] \qquad (23)$$

Ähnliche Formeln geben die Werte für $p_{v,x}$ und $p_{w,x}$. Zur Vereinfachung der Durchführung des Cordic-Verfahrens wird $\varphi$ so gewählt, dass $\frac{1}{\sqrt{3}} \tan \varphi = 2^n$ für die n-Iteration ergibt. Die Wurzel aus Verwendung der Wurzel aus 3 ergibt sich aus der Modifizierung des Cordic-Verfahrens für das Dreiphasensystem.

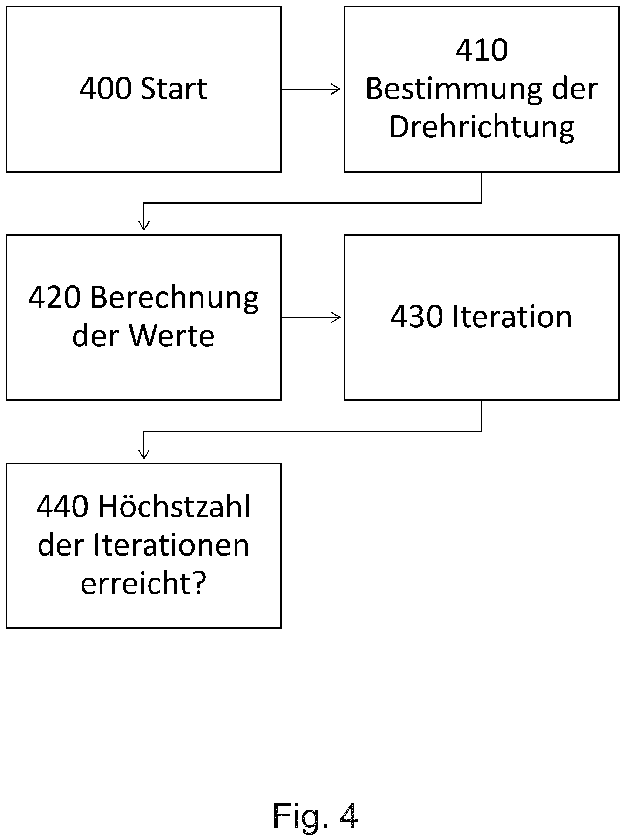

Demzufolge kann man ein Algorithmus mit den folgenden Schritten programmieren. Dieser ist in Fig. 4 dargestellt.

Zunächst wird bei Schritt 400 gestartet. In diesem Fall ist der Winkel = 0°. Es handelt sich um die erste Iteration (i=1) und n=1. Im Schritt 410 wird die Drehrichtung bestimmt durch das Vorzeichen (sgn) der folgenden Formel:

$$Drehrichtung = sgn \left( p_{w,x} - p_{v,x} \right) \qquad (24)$$

Die Werte $p_{u,x}$, $p_{v,x}$ und $p_{w,x}$ werden im Schritt 320 so berechnet:

$$p_{u,x} = \left[ p_{u,x,old} - 2^n \left( p_{v,x,old} - p_{w,x,old} \right) \right] \quad (25)$$

$$p_{v,x} = \left[ p_{v,x,old} - 2^n \left( p_{w,x,old} - p_{u,x,old} \right) \right] \quad (26)$$

$$p_{w,x} = \left[ p_{w,x,old} - 2^n \left( p_{u,x,old} - p_{v,x,old} \right) \right] \quad (27)$$

Der Winkel hat somit den folgenden Wert nach der ersten Iteration:

$$Winkel_{neu} = Winkel_{alt} + Drehrichtung \cdot arctan\left( 2^n \cdot \sqrt{3} \right) \qquad (28)$$

Im nächste Schritt 430 wird der Wert der Iteration um 1 erhöht, d.h. Iteration i = i +1 und der Wert der Rotation um die Hälfte reduziert, d.h. n = n -1. Solange der Wert der Iteration unter der Höchstzahl der Iterationen liegt (Schritt 440), wird die Berechnung im Schritt 420 wiederholt, wobei der Wert des $Winkel_{alt}$ dem in der vorherigen Iteration berechneten Wert $Winkel_{neu}$ entspricht.

Sollte die Höchstzahl der Iterationen erreicht werden, nimmt man den Wert $Winkel_{neu}$.

Die Koeffizientantabelle mit den arctan Werten (dritte Spalte) ist in dem Prozessor 40 abgespeichert und beschleunigt die Berechnung. Diese Koeffizientantabelle ist als eine "Look-Up"-Tabelle implementiert, auf die ein schneller Datenzugriff möglich ist.

Wie aus dieser Koeffizientantabelle zu entnehmen ist, wird der Änderung des Winkels mit zunehmender Anzahl an Iterationen immer kleiner. Ist die erforderliche Genauigkeit erreicht, wird die Berechnung beendet.

Das Verfahren kann die Daten aus dem Drei-Phasen-System unmittelbar verarbeiten, da der Algorithmus die Vektoren um mehr als +-220°C drehen kann (erste Iteration in der Koeffizientantabelle). Auf Grund des Drehbereichs, der mehr als 180° umfasst, ist das Verfahren gegen Fehlentscheidungen robust. Durch die Zusammenfassung von Signalen von gegenüberliegenden Sensoren 25 werden auch Offsets kompensiert.

Das Winkelerfassungssystem 5 der vorliegenden Erfindung findet beispielsweise Anwendung in Motoren und Wechselrichter sowie in Sensoren für z.B. Gaspedale.

Bezugszeichen

5    Winkelerfassungssystem
10   Dauermagnet
20   Sensorplatte
25   Sensoren

30 Kreislinie
40 Prozessor
50 Symmetriezentrum

**Patentansprüche**

1. Verfahren zur Berechnung der Phasenverschiebung eines elektromagnetischen Drei-Phasen-Systems umfassend:

   Erfassung von Vektorwerten (U, V, W) entsprechend einer elektromagnetischen Größe durch drei weitgehend gleichwinklig auf einer Kreislinie angeordneten Sensoren (25), die im Wesentlichen ein um 0°, 120° und 240° verschobenes Signal (Su', Sv', Sw') liefern;
   Berechnung von geänderten Vektorwerten durch Zurücksetzen eines der erfassten Vektorwerte (U, V, W) auf einen Winkel von 0°; und
   iterative Berechnung der Phasenverschiebung des Drei-Phasen-Systems durch ein Cordic-Verfahren mit Hilfe der geänderten Vektorwerte.

2. Verfahren zur Berechnung der Phasenverschiebung eines elektromagnetischen Drei-Phasen-Systems umfassend:

   Erfassung von Vektorwerten (U, V, W) entsprechend einer elektromagnetischen Größe durch sechs weitgehend gleichwinklig auf einer Kreislinie angeordneten Sensoren (25), wobei die Messwerte aus den jeweiligen gegenüberliegenden Sensoren zusammen gebildet werden, um im Wesentlichen ein um 0°, 120° und 240° verschobenes Signal (Su', Sv', Sw') zu liefern;
   Berechnung von geänderten Vektorwerten durch Zurücksetzen eines der erfassten Vektorwerte (U, V, W) auf einen Winkel von 0°; und
   iterative Berechnung der Phasenverschiebung des Drei-Phasen-Systems durch ein Cordic-Verfahren mit Hilfe der geänderten Vektorwerte.

3. Verfahren nach Anspruch 2, wobei die Vektorwerte (U, V, W) durch Zusammenfassen der normalisierten Signale (Su, Sv, Sw) von den Sensoren (25) gebildet werden.

4. Verfahren nach einem der Ansprüche 1 bis 3, wobei die iterative Berechnung mit Hilfe einer abgespeicherten Koeffiziententabelle mit den Werten von arctan $(\sqrt{3} * 2^n)$ für n=1,0,...-12 durchgeführt wird.

5. System zur Berechnung eines Winkels umfassend:

   drei Sensoren (25) zur Erfassung einer elektromagnetischen Größe, wobei die drei Sensoren (25) weitgehend gleichwinklig auf einer Kreislinie (30) angeordnet sind;
   einen Prozessor (40), der Werte der drei Sensoren (25) annimmt und das Verfahren nach Anspruch 1 oder 4 wenn abhängig von Anspruch 1 durchführt.

6. System zur Berechnung eines Winkels umfassend:

   sechs Sensoren (25) zur Erfassung einer elektromagnetischen Größe, wobei die sechs Sensoren (25) weitgehend gleichwinklig auf einer Kreislinie (30) angeordnet sind;
   einen Prozessor (40), der Werte der sechs Sensoren (25) annimmt und das Verfahren nach Anspruch 2,3 oder 4 durchführt.

7. System nach Anspruch 5 oder 6, wobei die Sensoren (25) Hall-Sensoren sind.

**Claims**

1. A method for calculating the phase shift of an electromagnetic three-phase system comprising:

   detecting vector values (U, V, W) corresponding to an electromagnetic quantity by three sensors (25) arranged substantially equiangularly on a circular line, the sensors substantially providing a signal (Su', Sv', Sw') shifted

---

**EP 3 270 113 B1**

by 0°, 120° and 240°;
calculating changed vector values by resetting one of the detected vector values (U, V, W) to an angle of 0°; and
iteratively calculating the phase shift of the three-phase system by a Cordic method using the changed vector values.

2. A method for calculating the phase shift of a three-phase electromagnetic system comprising:

detecting vector values (U, V, W) corresponding to an electromagnetic quantity by six sensors (25) arranged substantially equiangularly on a circular line, wherein the measured values from the respective opposing sensors being formed together to substantially provide a signal (Su', Sv', Sw') shifted by 0°, 120° and 240°;
calculating changed vector values by resetting one of the detected vector values (U, V, W) to an angle of 0°; and
iteratively calculating the phase shift of the three-phase system by a Cordic method using the changed vector values.

3. The method according to claim 2, wherein the vector values (U,V,W) are formed by combining the normalized signals (Su, Sv, Sw) of the sensors (25).

4. The method according to any one of claims 1 to 3, wherein the iterative calculation is executed using a stored coefficient table with the values of arctan $(\sqrt{3} * 2^n)$ for n=1,0,...-12.

5. A system for calculating an angle comprising:

three sensors (25) for detecting an electromagnetic quantity, wherein the three sensors (25) being arranged substantially equiangularly on a circular line (30);
a processor (40) accepting values from the three sensors (25) and executing the method of claim 1 or 4 if dependent on claim 1.

6. A system for calculating an angle comprising:

six sensors (25) for detecting an electromagnetic quantity, the six sensors (25) being arranged substantially equiangularly on a circular line (30);
a processor (40) accepting values from the six sensors (25) executing the method of claim 2,3, or 4.

7. The system according to claims 5 or 6, wherein the sensors (25) are Hall sensors.


**Revendications**

1. Procédé de calcul du déphasage d'un système électromagnétique triphasé comprenant :

détection de valeurs vectorielles (U, V, W) correspondant à une grandeur électromagnétique par trois capteurs (25) disposés de façon sensiblement équiangulaire sur une ligne circulaire qui fournissent un signal (Su', Sv', Sw') sensiblement décalé de 0°, 120° et 240° ;
calcul de valeurs vectorielles modifiées en remettant l'une des valeurs vectorielles détectées (U, V, W) à un angle de 0° ; et
calcul de manière itérative du déphasage du système triphasé par une méthode Cordic à l'aide des valeurs vectorielles modifiées.

2. Procédé de calcul du déphasage d'un système électromagnétique triphasé comprenant :

détection de valeurs vectorielles (U, V, W) correspondant à une grandeur électromagnétique par six capteurs (25) disposés de façon sensiblement équiangulaire sur une ligne circulaire, dans lequel les valeurs mesurées par les capteurs respectifs opposés sont formées ensemble pour fournir un signal (Su', Sv', Sw') décalé sensiblement de 0°, 120° et 240° ;
calcul de valeurs vectorielles modifiées en remettant l'une des valeurs vectorielles détectées (U, V, W) à un angle de 0° ; et
calcul de manière itérative du déphasage du système triphasé par une méthode Cordic à l'aide des valeurs vectorielles modifiées.

3. Procédé selon la revendication 2, dans lequel les valeurs vectorielles (U, V, W) sont formées en combinant les signaux normalisés (Su, Sv, Sw) provenant des capteurs (25).

4. Procédé selon l'une quelconque des revendications 1 à 3, dans lequel le calcul itératif est effectué en utilisant une table de coefficients mémorisée avec les valeurs de $\arctan(\sqrt{3}*2^n)$ pour n=1, 0 , ...-12.

5. Système pour calculer un angle comprenant :

trois capteurs (25) pour détecter une grandeur électromagnétique, dans lequel les trois capteurs (25) sont disposés de manière sensiblement équiangulaire sur une ligne circulaire (30) ;
un processeur (40) acceptant des valeurs provenant des trois capteurs (25) et exécutant le procédé selon la revendication 1 ou 4 lorsqu'elle est dépendante de la revendication 1.

6. Système pour calculer un angle comprenant :

six capteurs (25) pour détecter une grandeur électromagnétique, dans lequel les six capteurs (25) sont disposés de manière sensiblement équiangulaire sur une ligne circulaire (30) ;
un processeur (40) acceptant des valeurs provenant des six capteurs (25) et exécutant le procédé selon la revendication 2, 3 ou 4.

7. Système selon la revendication 5 ou 6, dans lequel les capteurs (25) sont des capteurs à effet Hall.

Fig. 1

Fig. 2

Fig. 3

400 Start

410 Bestimmung der Drehrichtung

420 Berechnung der Werte

430 Iteration

440 Höchstzahl der Iterationen erreicht?

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8736258 B, Trontelj
- DE 10320057 A1, Schödlbauer
- DE 102014109693 A1
- DE 102013020730 A1
- DE 102010003292 A1
- US 2015077093 A1
- EP 1471332 A1